# EUROPEAN PATENT APPLICATION

(11) **EP 4 685 841 A1**
(43) Date of publication of application: **28.01.2026**
(21) Application number: 24774981.5
(22) Date of filing: 22.03.2024
(51) Int. Cl.: H01L 21/3065, C23C 16/44, H01L 21/31

(54) **ETCHING METHOD, SEMICONDUCTOR DEVICE PRODUCTION METHOD, PROGRAM, AND PROCESSING DEVICE**

(30) Priority: 22.03.2023 JP 2023045666
(71) Applicant: Kokusai Electric Corporation, Tokyo 101-0045 (JP)
(72) Inventor: OGAWA, Arito, Toyama-shi, Toyama 939-2393 (JP); HAYASAKA, Shogo, Toyama-shi, Toyama 939-2393 (JP)
(74) Representative: Verscht, Thomas Kurt Albert
(86) International application number: PCT/JP2024/011187
(87) International publication number: WO 2024/195847

(57) **Abstract**

The present invention provides technology with which it is possible to efficiently remove a film. The present invention comprises a step for supplying a first gas that contains a first halogen element and a second gas that contains a second halogen element to a film so as to remove at least a part of the film.

## Description

### [Technical Field]

The present disclosure relates to an etching method, a method of manufacturing a semiconductor device, a program and a substrate processing apparatus.

### [Related Art]

For example, a gas containing boron and a halogen element may be used to remove the film (see, for example, Patent Document 1).

### [Related Art Document]

### [Patent Document]

Patent Document 1: Japanese Patent Application Laid-Open No. 2021-158142.

### [Disclosure]

### [Technical Problem]

However, when using a gas containing boron and a halogen element, an etching rate may be low, and a film may not be sufficiently removed. Therefore, a better method of removing the film is desired.

According to the present disclosure, there is provided a technique capable of efficiently removing a film.

### [Technical Solution]

According to an embodiment of the present disclosure, there is provided a technique that includes a step of removing at least a part of a film by supplying a first gas containing a first halogen element and a second gas containing a second halogen element to the film.

### [Advantageous Effects]

According to some embodiments of the present disclosure, it is possible to efficiently remove a film.

### [Brief Description of Drawings]

FIG. 1 is a diagram schematically illustrating a vertical cross-section of a process furnace 202 of a substrate processing apparatus used in embodiments of the present disclosure.
FIG. 2 is a diagram schematically illustrating a horizontal cross-section, taken along a line A - A shown in FIG. 1, of the process furnace 202 of the substrate processing apparatus used in the embodiments of the present disclosure.
FIG. 3 is a block diagram schematically illustrating a configuration of a controller 121 and related components of the substrate processing apparatus used in the embodiments of the present disclosure.
FIG. 4 is a flow chart schematically illustrating a process flow of the substrate processing apparatus used in the embodiments of the present disclosure.
FIG. 5 is a diagram schematically illustrating an example of a film forming step according to the embodiments.
FIG. 6 is a diagram schematically illustrating examples of a cleaning step and a component removing step according to the embodiments.
FIG. 7 is a diagram schematically illustrating an example of a pre-coating step according to the embodiments.
FIGS. 8(A) to 8(F) are diagrams schematically illustrating modified examples of the cleaning step according to the embodiments.
FIGS. 9(A) to 9(E) are diagrams schematically illustrating modified examples of the cleaning step according to the embodiments.
FIGS. 10(A) to 10(C) are diagrams schematically illustrating modified examples of the cleaning step according to the embodiments.

### [Detailed Description]

### <Embodiments of Present Disclosure>

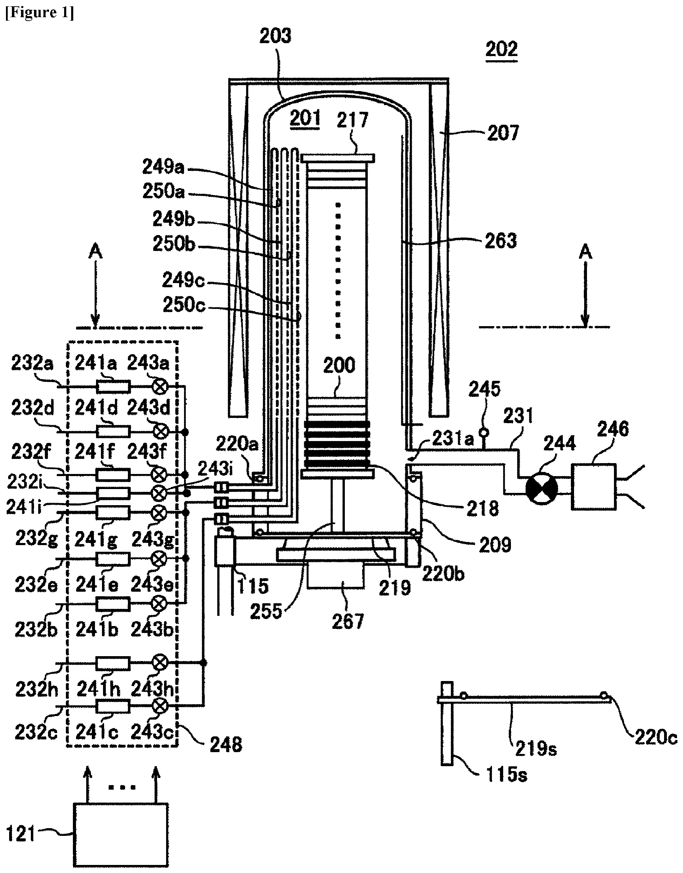

Hereinafter, embodiments according to the present disclosure will be described mainly with reference to FIGS. 1 to 7. For example, the drawings used in the following description are all schematic, and a relationship between dimensions of each component and a ratio of each component shown in the drawing may not always match the actual ones. In addition, even between the drawings, the relationship between the dimensions of each component and the ratio of each component may not always match.

### (1) Configuration of Substrate Processing Apparatus

As shown in FIG. 1, a process furnace 202 includes a heater 207 serving as a temperature regulator (which is a heating structure). The heater 207 is of a cylindrical shape, and is vertically installed while being supported by a support plate (not shown). The heater 207 also functions as an activator (also referred to as an "exciter") capable of activating (or exciting) a gas by a heat.

A reaction tube 203 is provided in an inner side of the heater 207 to be aligned in a manner concentric with the heater 207. For example, the reaction tube 203 is made of a heat resistant material such as quartz (SiO₂) and silicon carbide (SiC). For example, the reaction tube 203 is of a cylindrical shape with a closed upper end and an open lower end. A manifold 209 (hereinafter also referred to as an "MF 209") is provided under the reaction tube 203 to be aligned in a manner concentric with the reaction tube 203. For example, the MF 209 is made of a metal material such as stainless steel (SUS). For example, the MF 209 is of a cylindrical shape with open upper and lower ends. An upper end portion of the MF 209 is engaged with a lower end portion of the reaction tube 203 so as to support the reaction tube 203. An O-ring 220a serving as a seal is provided between the MF 209 and the reaction tube 203. Similar to the heater 207, the reaction tube 203 is installed vertically. A process vessel (also referred to as a "reaction vessel") is constituted mainly by the reaction tube 203 and the MF 209. A process chamber 201 is provided in a hollow cylindrical portion of the process vessel. The process chamber 201 is configured to be capable of accommodating a wafer 200 serving as a substrate. The wafer 200 is processed in the process chamber 201.

Nozzles 249a, 249b and 249c are provided in the process chamber 201 so as to penetrate a side wall of the MF 209. The nozzle 249a serves as a first supply structure, the nozzle 249b serves as a second supply structure and the nozzle 249c serves as a third supply structure. The nozzles 249a, 249b and 249c may also be referred to as a first nozzle, a second nozzle and a third nozzle, respectively. For example, each of the nozzles 249a, 249b and 249c is made of a heat resistant material such as quartz and silicon carbide (SiC). Gas supply pipes 232a, 232b and 232c are connected to the nozzles 249a, 249b and 249c, respectively. The nozzles 249a, 249b and 249c are different nozzles, and the nozzles 249a and 249c are provided adjacent to the nozzle 249b.

Mass flow controllers (also simply referred to as "MFCs") 241a, 241b and 241c serving as flow rate controllers (flow rate control structures) and valves 243a, 243b and 243c serving as opening/closing valves are sequentially installed at the gas supply pipes 232a, 232b and 232c, respectively, in this order from upstream sides to downstream sides of the gas supply pipes 232a, 232b and 232c in a gas flow direction. Gas supply pipes 232d, 232f and 232i are connected to the gas supply pipe 232a at a downstream side of the valve 243a. Gas supply pipes 232e and 232g are connected to the gas supply pipe 232b at a downstream side of the valve 243b. A gas supply pipe 232h is connected to the gas supply pipe 232c at a downstream side of the valve 243c. MFCs 241d to 241i and valves 243d to 243i are sequentially installed at the gas supply pipes 232d to 232i, respectively, in this order from upstream sides to downstream sides of the gas supply pipes 232d to 232i in the gas flow direction. For example, each of the gas supply pipes 232a to 232i is made of a metal material such as SUS.

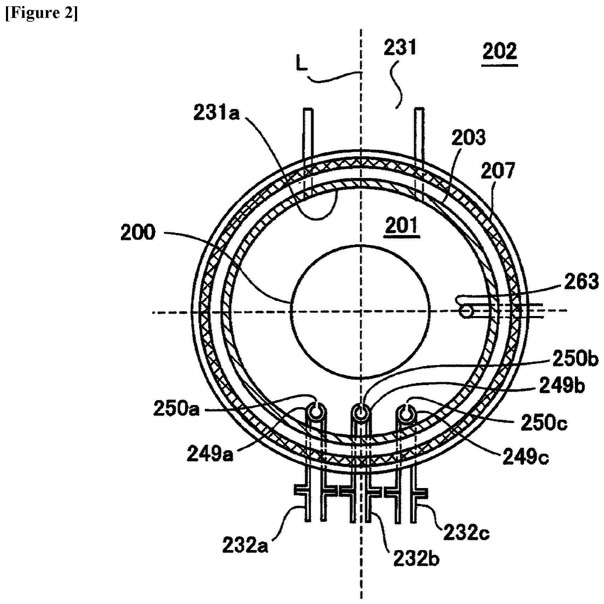

As shown in FIG. 2, each of the nozzles 249a to 249c is installed in an annular space provided between an inner wall of the reaction tube 203 and the wafers 200 when viewed from above, and extends upward from a lower portion toward an upper portion of the reaction tube 203 along the inner wall of the reaction tube 203 (that is, extends upward along an arrangement direction of the wafers 200). That is, each of the nozzles 249a to 249c is installed in a region that is located beside and horizontally surrounds a wafer arrangement region in which the wafers 200 are arranged (stacked) along the wafer arrangement region. When viewed from above, the nozzle 249b is arranged so as to face an exhaust port 231a described later along a straight line with a center of the wafer 200 transferred (loaded) into the process chamber 201 interposed therebetween. The nozzles 249a and 249c are arranged along the inner wall of the reaction tube 203 (that is, along an outer periphery of the wafer 200) such that a straight line L passing through the nozzle 249b and a center of the exhaust port 231a is interposed therebetween. The straight line L may also be referred to as a straight line passing through the nozzle 249b and the center of the wafer 200. That is, it can be said that the nozzle 249c is provided opposite to the nozzle 249a with the straight line L interposed therebetween. The nozzles 249a and 249c are arranged line-symmetrically (that is, in a line symmetry) with respect to the straight line L serving as an axis of symmetry. A plurality of gas supply holes 250a, a plurality of gas supply holes 250b and a plurality of gas supply holes 250c are provided at side surfaces of the nozzles 249a, 249b and 249c, respectively. Gases are supplied via the gas supply holes 250a, the gas supply holes 250b and the gas supply holes 250c, respectively. The gas supply holes 250a, the gas supply holes 250b and the gas supply holes 250c are open toward the exhaust port 231a when viewed from above, and are configured such that the gases are supplied toward the wafers 200 via the gas supply holes 250a, the gas supply holes 250b and the gas supply holes 250c. The gas supply holes 250a, the gas supply holes 250b and the gas supply holes 250c are provided from the lower portion toward the upper portion of the reaction tube 203.

A first process gas serving as a source gas is supplied into the process chamber 201 through the gas supply pipe 232a provided with the MFC 241a and the valve 243a and the nozzle 249a. As the first process gas, for example, a gas such as a metal element-containing gas and a silicon (Si)-containing gas may be used.

A second process gas serving as a reactive gas is supplied into the process chamber 201 through the gas supply pipe 232b provided with the MFC 241b and the valve 243b and the nozzle 249b. As the second process gas, for example, a gas such a nitriding gas may be used.

A third process gas serving as a reducing gas is supplied into the process chamber 201 through the gas supply pipe 232c provided with the MFC 241c and the valve 243c and the nozzle 249c. As the third process gas, for example, a gas such a gas containing silicon and hydrogen (H) may be used.

A first gas is supplied into the process chamber 201 through the gas supply pipe 232d provided with the MFC 241d and the valve 243d, the gas supply pipe 232a and the nozzle 249a. As the first gas, for example, a first halogen element-containing gas may be used. In addition, the first gas may also be referred to as a "first cleaning gas" or a "first etching gas". In addition, in the present disclosure, the term "cleaning" may also be expressed as "CLN". Therefore, the cleaning gas may also be referred to as a "CLN gas".

A second gas is supplied into the process chamber 201 through the gas supply pipe 232e provided with the MFC 241e and the valve 243e, the gas supply pipe 232b and the nozzle 249b. As the second gas, for example, a second halogen element-containing gas may be used. In addition, the second gas may also be referred to as a "second CLN gas" or a "second etching gas".

A fourth process gas serving as the source gas is supplied into the process chamber 201 through the gas supply pipe 232f provided with the MFC 241f and the valve 243f, the gas supply pipe 232a and the nozzle 249a. As the fourth process gas, for example, a gas such as a metal element-containing gas and a silicon-containing gas may be used.

An inert gas is supplied into the process chamber 201 via the gas supply pipes 232g to 232i provided with the MFCs 241g to 241i and the valves 243g to 243i, respectively, the gas supply pipes 232ga to 232i and the nozzles 249a to 249c. For example, the inert gas may act as a purge gas, a carrier gas, a dilution gas and the like.

A first process gas supplier (which is a first process gas supply system) is constituted mainly by the gas supply pipe 232a, the MFC 241a and the valve 243a. A second process gas supplier (which is a second process gas supply system) is constituted mainly by the gas supply pipe 232b, the MFC 241b and the valve 243b. A third process gas supplier (which is a third process gas supply system) is constituted mainly by the gas supply pipe 232c, the MFC 241c and the valve 243c. A first gas supplier (which is a first gas supply system) is constituted mainly by the gas supply pipe 232d, the MFC 241d and the valve 243d. The first gas supplier may also be referred to as a "first CLN gas supplier" which is a first CLN gas system or a "first etching gas supplier" which is a first etching gas system. A second gas supplier (which is a second gas supply system) is constituted mainly by the gas supply pipe 232e, the MFC 241e and the valve 243e. The second gas supplier may also be referred to as a "second CLN gas supplier" which is a second CLN gas system or a "second etching gas supplier" which is a second etching gas system. A fourth process gas supplier (which is a fourth process gas supply system) is constituted mainly by the gas supply pipe 232f, the MFC 241f and the valve 243f. An inert gas supplier (which is an inert gas supply system) is constituted mainly by the gas supply pipes 232g to 232i, the MFCs 241g to 241i and the valves 243g to 243i.

Any one or an entirety of the gas suppliers described above may be configured as an integrated gas supply system 248 in which the components such as the valves 243a to 243i and the MFCs 241a to 241i are integrated. The integrated gas supply system 248 is connected to each of the gas supply pipes 232a to 232i. Operations of the integrated gas supply system 248 to supply various gases to the gas supply pipes 232a to 232i, for example, operations such as an operation of opening and closing the valves 243a to 243i and operations of adjusting flow rates of the gases by the MFCs 241a to 241i may be controlled by a controller 121 (hereinafter, also referred to as a "CNT 121") described later. The integrated gas supply system 248 may be embodied as an integrated structure (integrated unit) of an all-in-one type or a divided type. The integrated gas supply system 248 may be attached to or detached from the components such as the gas supply pipes 232a to 232i on a basis of the integrated structure. Operations such as maintenance, replacement and addition for the integrated gas supply system 248 may be performed on a basis of the integrated structure.

The exhaust port 231a through which an inner atmosphere of the process chamber 201 is exhausted is provided at a lower side wall of the reaction tube 203. As shown in FIG. 2, the exhaust port 231a is arranged at a location so as to face the nozzles 249a to 249c (the gas supply holes 250a to the gas supply holes 250c) with the wafer 200 interposed therebetween when viewed from above. The exhaust port 231a may be provided so as to extend upward from the lower portion toward the upper portion of the reaction tube 203 along a side wall of the reaction tube 203 (that is, along the wafer arrangement region). An exhaust pipe 231 is connected to the exhaust port 231a. A vacuum pump 246 serving as a vacuum exhaust apparatus is connected to the exhaust pipe 231 through a pressure sensor 245 and an APC (Automatic Pressure Controller) valve 244. The pressure sensor 245 serves as a pressure detector (pressure detection structure) configured to detect an inner pressure of the process chamber 201, and the APC valve 244 serves as a pressure regulator (pressure adjusting structure). With the vacuum pump 246 in operation, the APC valve 244 may be opened or closed to perform a vacuum exhaust operation for the process chamber 201 or stop the vacuum exhaust operation. In addition, with the vacuum pump 246 in operation, the inner pressure of the process chamber 201 may be adjusted by adjusting an opening degree of the APC valve 244 based on pressure information detected by the pressure sensor 245. An exhauster (which is an exhaust system) is constituted mainly by the exhaust pipe 231, the APC valve 244 and the pressure sensor 245. The exhauster may further include the vacuum pump 246.

A seal cap 219 (hereinafter, also referred to as a "SC 219") serving as a furnace opening lid capable of airtightly sealing (closing) a lower end opening of the MF 209 is provided under the MF 209. For example, the SC 219 is made of a metal material such as SUS, and is of a disk shape. An O-ring 220b serving as a seal is provided on an upper surface of the SC 219 so as to be in contact with the lower end of the MF 209. A rotator (which is a rotating structure) 267 configured to rotate a boat 217 described later is provided under the SC 219. For example, a rotating shaft 255 of the rotator 267 is connected to the boat 217 through the SC 219. The rotator 267 is configured to rotate the wafers 200 by rotating the boat 217. The SC 219 is configured to be elevated or lowered in the vertical direction by a boat elevator 115 (hereinafter, also referred to as a "BE 115") serving as an elevating structure provided outside the reaction tube 203. The BE 115 serves as a transfer apparatus (which is a transfer structure) capable of transferring (loading) the wafers 200 accommodated in the boat 217 into the process chamber 201 and capable of transferring (unloading) the wafers 200 out of the process chamber 201 by elevating and lowering the SC 219.

A shutter 219s serving as a furnace opening lid capable of airtightly sealing (closing) the lower end opening of the MF 209 is provided under the MF 209. The shutter 219s is configured to close the lower end opening of the MF 209 when the SC 219 is lowered by the BE 115 and the boat 217 is unloaded out of the process chamber 201. For example, the shutter 219s is made of a metal material such as SUS, and is of a disk shape. An O-ring 220c serving as a seal is provided on an upper surface of the shutter 219s so as to be in contact with the lower end of the MF 209. An opening and closing operation of the shutter 219s such as an elevation operation and a rotation operation is controlled by a shutter opener/closer (which is a shutter opening/closing structure) 115s.

The boat 217 serving as a substrate support is configured such that the wafers 200 (for example, 25 wafers to 200 wafers) are supported (or stacked) in the vertical direction in the boat 217 while the wafers 200 are horizontally oriented with their centers aligned with one another in a multistage manner. That is, the boat 217 is configured such that the wafers 200 are arranged in the vertical direction in the boat 217 while the wafers 200 are stacked in the vertical direction with a predetermined interval therebetween. For example, the boat 217 is made of a heat resistant material such as quartz and SiC. For example, a plurality of heat insulation plates 218 made of a heat resistant material such as quartz and SiC are supported at a lower portion of the boat 217 in a multistage manner.

A temperature sensor 263 serving as a temperature detector is installed in the reaction tube 203. A state of electric conduction to the heater 207 is adjusted based on temperature information detected by the temperature sensor 263 such that a desired temperature distribution of an inner temperature of the process chamber 201 can be obtained. The temperature sensor 263 is provided along the inner wall of the reaction tube 203.

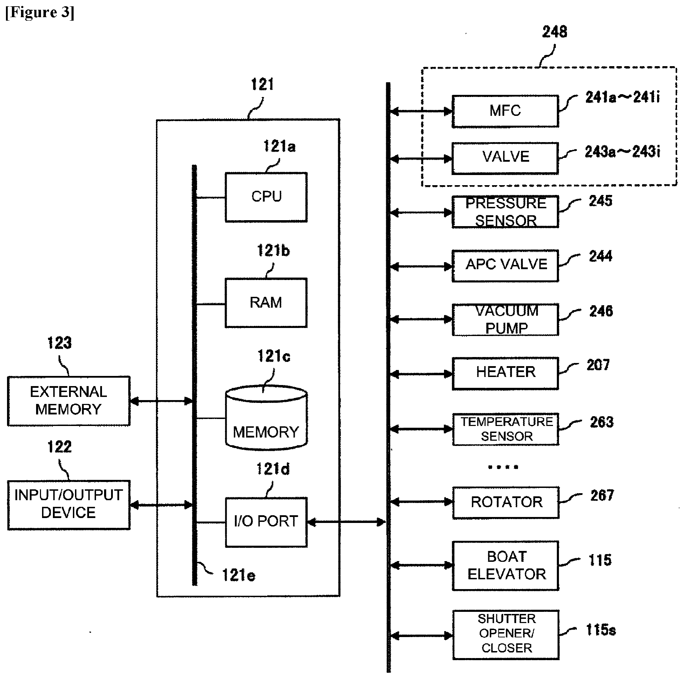

As shown in FIG. 3, the CNT 121 serving as a control structure (control apparatus) is constituted by a computer including a CPU (Central Processing Unit) 121a, a RAM (Random Access Memory) 121b, a memory 121c and an I/O port (input/output port) 121d. The RAM 121b, the memory 121c and the I/O port 121d are configured to be capable of exchanging data with the CPU 121a through an internal bus 121e. For example, an input/output device 122 constituted by a component such as a touch panel is connected to the CNT 121. In addition, the CNT 121 is configured to be capable of being connected to an external memory 123. For example, as the control structure, the substrate processing apparatus may include a single control structure, or include a plurality of control structures. That is, a control operation of performing a process sequence described later may be performed using the single control structure, or may be performed using the plurality of control structures. In addition, the plurality of control structures may be configured as a control system that are connected to one another via a wired or wireless communication network, and an entirety of the control system may perform the control operation of performing the process sequence described below. Thus, in the present specification, the term "control structure" may refer to the single control structure, may refer to the plurality of control structures, or may refer to the control system configured by the plurality of control structures.

For example, the memory 121c is configured by a component such as a flash memory, a hard disk drive (HDD) and a solid state drive (SSD). For example, a control program configured to control an operation of the substrate processing apparatus and a process recipe containing information on procedures and conditions of a substrate processing described later may be readably stored in the memory 121c. The process recipe is obtained by combining steps (procedures) of the substrate processing described later such that the CNT 121 can execute the steps by the substrate processing apparatus to acquire a predetermined result, and functions as a program. Hereinafter, the process recipe and the control program may be collectively or individually referred to as a "program". In addition, the process recipe may also be simply referred to as a "recipe". Thus, in the present specification, the term "program" may refer to the recipe alone, may refer to the control program alone or may refer to both of the recipe and the control program. The RAM 121b functions as a memory area (work area) where a program or data read by the CPU 121a is temporarily stored.

The I/O port 121d is connected to the components described above such as the MFCs 241a to 241i, the valves 243a to 243i, the pressure sensor 245, the APC valve 244, the vacuum pump 246, the temperature sensor 263, the heater 207, the rotator 267, the BE 115 and the shutter opener/closer 115s.

The CPU 121a is configured to read the control program from the memory 121c and execute the control program read from the memory 121c. In addition, the CPU 121a is configured to read the recipe from the memory 121c, for example, in accordance with an operation command inputted from the input/output device 122. In accordance with contents of the recipe read from the memory 121c, the CPU 121a may be configured to be capable of controlling various operations such as flow rate adjusting operations for various substances (various gases) by the MFCs 241a to 241i, opening and closing operations of the valves 243a to 243i, an opening and closing operation of the APC valve 244, a pressure adjusting operation by the APC valve 244 based on the pressure sensor 245, a start and stop operation of the vacuum pump 246, a temperature adjusting operation by the heater 207 based on the temperature sensor 263, an operation of adjusting a rotation and a rotation speed of the boat 217 by the rotator 267, an elevating and lowering operation of the boat 217 by the BE 115 and an opening and closing operation of the shutter 219s by the shutter opener/closer 115s.

The CNT 121 may be embodied by installing the above-described program stored in the external memory 123 into the computer. For example, the external memory 123 may include a magnetic disk such as the HDD, an optical disk such as a CD, a magneto-optical disk such as an MO and a semiconductor memory such as a USB memory and the SSD. The memory 121c or the external memory 123 may be embodied by a non-transitory computer readable recording medium. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123. Instead of the external memory 123, a communication interface such as the Internet and a dedicated line may be used for providing the program to the computer.

### (2) Substrate Processing

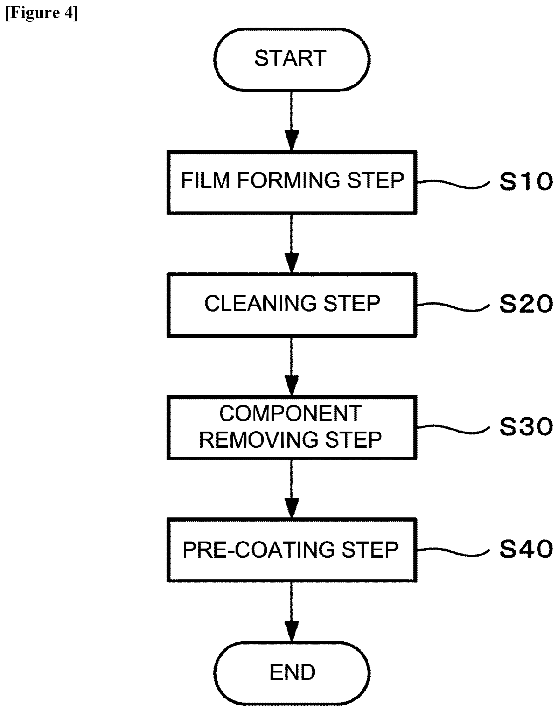

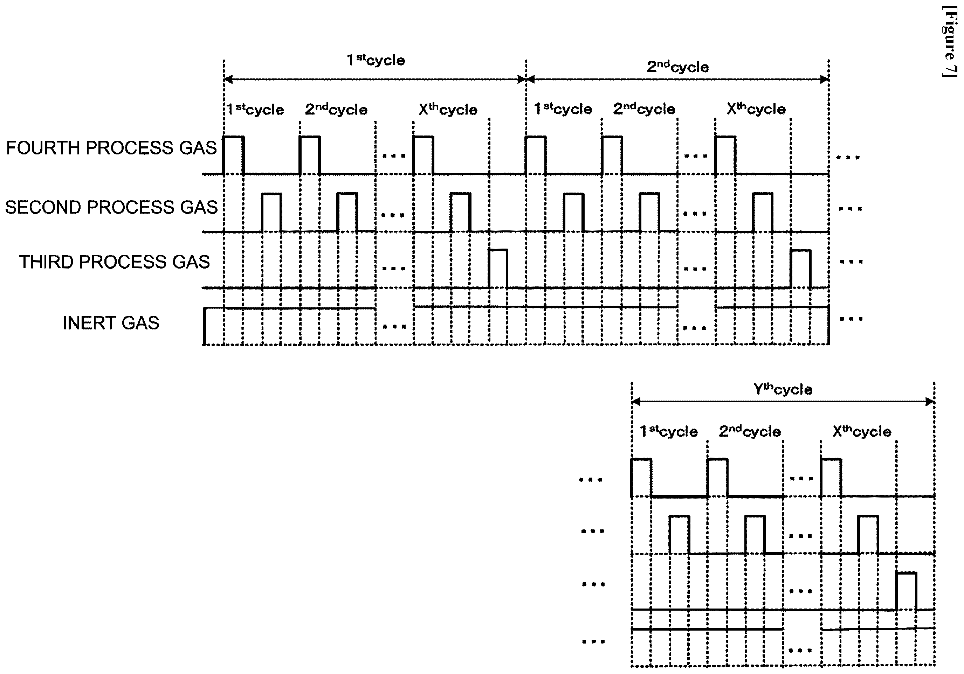

Hereinafter, an example of a series of process sequences including a film forming process of the substrate processing of forming a film on the wafer 200 by using the substrate processing apparatus described above, which is a part of a manufacturing process of a semiconductor device, will be described mainly with reference to FIGS. 4 and 7. In the following description, operations of components constituting the substrate processing apparatus are controlled by the CNT 121.

### <Film Forming Step, Step S10>

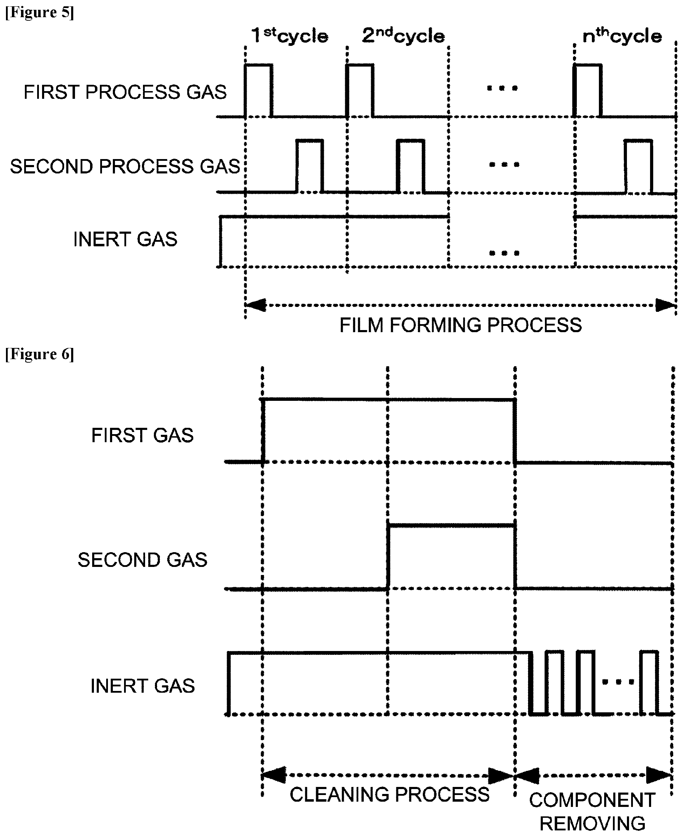

First, the film forming step of loading the wafer 200 into the process furnace 202 and forming the film on the wafer 200 will be described with reference to FIG. 5.

In the present specification, the term "wafer" may refer to "a wafer itself", or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". Thus, in the present specification, "forming a predetermined layer (or a film) on a wafer" may refer to "forming a predetermined layer (or a film) directly on a surface of a wafer itself", or may refer to "forming a predetermined layer (or a film) on a surface of another layer (or another film) formed on a wafer". In the present specification, the terms "substrate" and "wafer" may be used as substantially the same meaning.

### <Substrate Loading Step>

The wafers 200 are charged (loaded or transferred) into the boat 217. Then, as shown in FIG. 1, the boat 217 supporting the wafers 200 is elevated by the BE 115 and loaded (transferred) into the process chamber 201. In such a state, the SC 219 airtightly seals the lower end opening of the reaction tube 203 via the O-ring 220b.

The vacuum pump 246 vacuum-exhausts the inner atmosphere of the process chamber 201 (that is, a space in which the wafers 200 are present (accommodated)) such that the inner pressure of the process chamber 201 reaches and is maintained at a desired pressure (vacuum degree). At this time, the inner pressure of the process chamber 201 is measured by the pressure sensor 245, and the APC valve 244 is feedback-controlled based on the pressure information detected by the pressure sensor 245 (pressure adjusting step). In addition, the heater 207 heats the process chamber 201 such that the inner temperature of the process chamber 201 reaches and is maintained at a desired temperature. At this time, the state of the electric conduction to the heater 207 is feedback-controlled based on the temperature information detected by the temperature sensor 263 such that a desired temperature distribution of the inner temperature of the process chamber 201 can be obtained (temperature adjusting step). In addition, a rotation of the wafer 200 is started by the rotator 267. The vacuum pump 246 continuously vacuum-exhausts the inner atmosphere of the process chamber 201, the heater 207 continuously heats the wafer 200 in the process chamber 201 and the rotator 267 continuously rotates the wafer 200 until at least a processing of the wafer 200 is completed.

### <Film Forming Process>

### <First Process Gas Supply Step S11>

In the first process gas supply step S11, the first process gas is supplied onto the wafer 200 in the process chamber 201. Specifically, the valve 243a is opened to supply the first process gas into the gas supply pipe 232a. After a flow rate of the first process gas is adjusted by the MFC 241a, the first process gas whose flow rate is adjusted is supplied into the process chamber 201 through the nozzle 249a, and is exhausted through the exhaust port 231a. In the present step, in parallel with a supply of the first process gas, the valve 243i is opened to supply the inert gas into the gas supply pipe 232a. In addition, in parallel with the supply of the first process gas, in order to prevent the first process gas from entering the nozzles 249b and 249c, the valves 243g and 243h may be opened to supply the inert gas into the gas supply pipes 232b and 232c.

In a manner described above, the first process gas is supplied onto the wafer 200. According to the present embodiments, as the first process gas, for example, a metal element-containing gas containing a metal element such as aluminum (Al), zirconium (Zr), hafnium (Hf), titanium (Ti), molybdenum (Mo), tungsten (W), gallium (Ga) and indium (In) may be used. In addition, as the first process gas, for example, instead of or in addition to the metal element-containing gas exemplified above, a gas such as the silicon-containing gas may be used. As the first process gas, for example, one or more of the gases exemplified above may be used.

As the inert gas, for example, nitrogen (N₂) gas or a rare gas such as argon (Ar) gas, helium (He) gas, neon (Ne) gas and xenon (Xe) gas may be used. As the inert gas, for example, one or more of the gases exemplified above may be used. The same also applies to each step described below.

### <Purge Step S12>

After the first layer is formed, the valve 243a is closed to stop the supply of the first process gas into the process chamber 201. Then, the inner atmosphere of the process chamber 201 is vacuum-exhausted. As a result, a substance such as a gas remaining in the process chamber 201 is removed from the process chamber 201 (purge operation). At this time, with the valves 243g, 243h and 243i open, the inert gas is continuously supplied into the process chamber 201. The inert gas acts as the purge gas.

### <Second Process Gas Supply Step S13>

Subsequently, the second process gas is supplied onto the wafer 200 (that is, onto the first layer formed on the wafer 200) in the process chamber 201. Specifically, the valve 243b is opened to supply the second process gas into the gas supply pipe 232b. After a flow rate of the second process gas is adjusted by the MFC 241b, the second process gas whose flow rate is adjusted is supplied into the process chamber 201 through the gas supply pipe 232b and the nozzle 249b, and is exhausted through the exhaust port 231a. In the present step, in parallel with a supply of the second process gas, the valve 243g is opened to supply the inert gas into the gas supply pipe 232b. In addition, in parallel with the supply of the second process gas, in order to prevent the second process gas from entering the nozzles 249a and 249c, the valves 243i and 243h may be opened to supply the inert gas into the gas supply pipes 232a and 232c.

In a manner described above, the second process gas is supplied onto the wafer 200. According to the present embodiments, as the second process gas, for example, a nitriding gas may be used. In addition, as the nitriding gas, for example, a hydrogen nitride gas such as NH₃ gas, N₂H₂ gas, N₂H₄ gas and N₃H₈ gas may be used. As the second process gas, for example, one or more of the gases exemplified above may be used.

### <Purge Step S14>

After the second layer is formed, the valve 243b is closed to stop the supply of the second process gas into the process chamber 201. Then, a substance such as a gas remaining in the process chamber 201 is removed from the process chamber 201 in substantially the same process procedures as in the purge operation of the purge step S12 described above.

### <Performing Predetermined Number of Times>

By performing a cycle wherein the steps S11 to S14 described above are performed non-simultaneously (that is, in a non-synchronized manner) in this order a predetermined number of times (n times, wherein n is an integer of 1 or 2 or more), it is possible to form a film of a predetermined composition and a predetermined thickness on the wafer 200.

According to the present embodiments, for example, as the film formed on the wafer 200, a nitride film is formed. As the nitride film, for example, a nitride film containing a Group 13 element may be formed. As the nitride film containing the Group 13 element, for example, a nitride film such as an aluminum nitride film (AlN film), a gallium nitride film (GaN film) and an indium nitride film (InN film) may be formed. As the nitride film, for example, in addition to or instead of the nitride film containing the Group 13 element, a nitride film containing the metal element mentioned above may be formed. As the nitride film, for example, a film such as a silicon nitride film (SiN film), a titanium nitride film (TiN film), a molybdenum nitride film (MoN film) and a tungsten nitride film (WN film) may be formed.

### <After-purge Step and Returning to Atmospheric Pressure Step>

After a process of forming the film on the wafer 200 is completed, the inert gas serving as the purge gas is supplied into the process chamber 201 through each of the nozzles 249a, 249b and 249c, and then is exhausted through the exhaust port 231a. Thereby, the inner atmosphere of the process chamber 201 is purged with the inert gas. As a result, a substance such as a gas remaining in the process chamber 201 and reaction by-products remaining in the process chamber 201 is removed from the process chamber 201. Thereafter, the inner atmosphere of the process chamber 201 is replaced with the inert gas, and the inner pressure of the process chamber 201 is returned to the normal pressure.

### <Substrate Unloading Step>

Thereafter, the SC 219 is lowered by the BE 115 and the lower end of the MF 209 is opened. Then, the boat 217 with the wafers 200 (which are processed and supported in the boat 217) is unloaded (transferred) out of the reaction tube 203 through the lower end of the MF 209. After the boat 217 is unloaded, the shutter 219s is moved such that the lower end opening of the MF 209 is sealed by the shutter 219s through the O-ring 220c. Then, the wafers 200 (which are processed) are discharged (transferred or unloaded) from the boat 217 unloaded out of the reaction tube 203.

When the film forming step mentioned above is performed, at an inner side of the process vessel, a deposit including the film such as the nitride film may adhere to and accumulate on a surface of a component in the process vessel, for example, the inner wall of the reaction tube 203, outer surfaces of the nozzles 249a to 249c, inner surfaces of the nozzles 249a to 249c, an inner surface of the MF 209, a surface of the boat 217 and the upper surface of the SC 219. When an amount of the deposit, that is, an accumulative thickness of the film is too thick, the deposit may peel off and an amount of particles generated thereby may increase. Therefore, a CLN step is performed to remove the deposit accumulated in the process vessel before the accumulative thickness of the film (the amount of the deposit) reaches a predetermined thickness (predetermined amount) before the deposit peels off or falls off.

### <CLN Step (Etching Step), Step S20>

Subsequently, the CLN step of loading an empty boat 217 into the process chamber 201 and performing a CLN process in the reaction tube 203 in which the film such as the nitride film is formed on the surface of the component such as the inner wall will be described with reference to FIG. 6. While the present embodiments are described by way of an example in which the CLN process is performed, by loading the boat 217 on which the wafers 200 with the film such as the nitride film is formed thereon are placed, it is possible to etch at least a part of the film such as the nitride film formed on the wafers 200.

### <Empty Boat Loading Step>

The shutter 219s is moved by the shutter opener/closer 115s such that the lower end opening of the MF 209 is opened. Thereafter, the empty boat 217 is elevated by the BE 115 and loaded into the process chamber 201. In such a state, the SC 219 airtightly seals the lower end of the MF 209 via the O-ring 220b.

After the empty boat 217 is loaded into the process chamber 201, the vacuum pump 246 vacuum-exhausts the inner atmosphere of the process chamber 201 such that the inner pressure of the process chamber 201 reaches and is maintained at a desired pressure. In addition, the heater 207 heats the process chamber 201 such that the inner temperature of the process chamber 201 reaches and is maintained at a desired temperature. In addition, the rotation of the boat 217 is started by the rotator 267. The vacuum pump 246 continuously vacuum-exhausts the inner atmosphere of the process chamber 201, the heater 207 continuously heats the process chamber 201 and the rotator 267 continuously rotates the boat 217 until at least the CLN step is completed. Alternatively, the boat 217 may not be rotated.

### <CLN Process (Etching Process)>

### <First Gas Supply Step S21>

First, the first gas is supplied into the process chamber 201. Specifically, the valve 243d is opened to supply the first gas into the gas supply pipe 232a. After a flow rate of the first gas is adjusted by the MFC 241d, the first gas whose flow rate is adjusted is supplied into the process chamber 201 through the nozzle 249a, and is exhausted through the exhaust pipe 231. In the present step, in parallel with a supply of the first gas, the valve 243i is opened to supply the inert gas into the gas supply pipe 232a. In addition, in parallel with the supply of the first gas, in order to prevent the first gas from entering the nozzles 249b and 249c, the valves 243g and 243h may be opened to supply the inert gas into the gas supply pipes 232b and 232c.

As the first gas, for example, a chlorine-containing gas containing chlorine (Cl) serving as a first halogen element may be used. As the chlorine-containing gas, for example, a gas containing chlorine and a Group 13 element such as boron (B), aluminum (Al) and gallium (Ga) may be used. As the gas containing chlorine and the Group 13 element, for example, one or more of the gases such as AlCl₃ gas, BCl₃ gas and GaCl₃ gas may be used.

That is, the first gas is supplied into the reaction tube 203 in which the nitride film serving as a CLN target (etching target) is formed on the surface of the component such as the inner wall. By supplying the first gas into the process chamber 201 in which the nitride film is deposited, it is possible to weaken a bond between nitrogen and other elements such as a metal element in the deposit deposited in the process chamber 201. Specifically, for example, when the film serving as the CLN target is a film containing the Group 13 element and a Group 15 element (for example, the AlN film), by using the first gas, it is possible to weaken a bond (for example, aluminum (Al) - nitrogen (N) bond) between the Group 13 element and the Group 15 element deposited in the process chamber 201 by an action of the Group 13 element (for example, boron (B) when the first gas is the BCl₃ gas).

### <Step of Simultaneously Supplying First Gas and Second Gas, Step S22>

After a predetermined time has elapsed from a start of the supply of the first gas, with the valves 243d and 243i open, the valve 243e is opened to supply the second gas into the gas supply pipe 232b. After a flow rate of the second gas is adjusted by the MFC 241e, the second gas whose flow rate is adjusted is supplied into the process chamber 201 through the nozzle 249b, and is exhausted through the exhaust pipe 231. In the present step, in parallel with a supply of the second gas, the valve 243g is opened to supply the inert gas into the gas supply pipe 232b. In addition, in parallel with the supply of the second gas, in order to prevent the second gas from entering the nozzle 249c, the valve 243h may be opened to supply the inert gas into the gas supply pipe 232c. In a manner described above, the first gas and the second gas are simultaneously supplied into the process chamber 201.

As the second gas, for example, a chlorine-containing gas containing chlorine (Cl) serving as a second halogen element may be used. As the chlorine-containing gas, for example, a gas containing chlorine and a Group 16 element such as sulfur (S) and oxygen (O) may be used. As the gas containing chlorine and the Group 16 element, for example, a gas containing one of S₂Cl₂, SOCl₂, SO₂Cl₂ and COCl₂ may be used. In addition, as the gas containing chlorine and the Group 16 element, for example, a gas containing two of the Group 16 elements such as sulfur and oxygen, that is, a gas containing one of SOCl₂, SO₂Cl₂, SeOCl₂, SeO₂Cl₂, SOF₂, SO₂F₂, SeOF₂ and SeO₂F₂ may be used. As the second gas, for example, one or more of the gases exemplified above may be used.

That is, the first gas and the second gas may contain, for example, chlorine which is a common halogen element, the first gas further contains another element, and the second gas further contains still another element different therefrom.

In the present step, the first gas and the second gas are supplied simultaneously to the nitride film serving as the CLN target. That is, in the CLN step (etching step), a timing at which the supply of the first gas is started and a timing at which the supply of the second gas is started are set to be different, and the supply of the second gas is started after the supply of the first gas is started. In addition, there is a timing at which the first gas and the second gas are simultaneously supplied.

By differentiating the timing at which the supply of the first gas is started and the timing at which the supply of the second gas is started, and by starting the supply of the second gas after the supply of the first gas is started, that is, by supplying the first gas before the second gas, it is possible to weaken a bond in the nitride film by an effect of an element such as boron contained in the first gas. Thereby, it is possible to easily etch the nitride film with the second gas. In addition, by simultaneously supplying the first gas and the second gas into the process chamber 201, it is possible to weaken the bond in the nitride film formed in the process vessel by the effect of the element such as boron contained in the first gas. Thereby, it is possible to easily etch the nitride film with the second gas. As a result, it is possible to efficiently perform the CLN (etching) in a short time.

After a predetermined time has elapsed and the CLN in the process chamber 201 is completed, the valves 243d and 243e are closed to stop the supply of the gas into the process chamber 201. Then, the inner atmosphere of the process chamber 201 is purged in substantially the same process procedures as in the purge operation described above. Thereafter, the inner atmosphere of the process chamber 201 is replaced with the inert gas.

Specifically, for example, an etching rate of a dry etching using the first gas is low. On the other hand, the CLN by the second gas is preferably performed at a high pressure. In addition, the second gas is expensive. When the CLN is performed on the film containing the group 13 element and the Group 15 element (for example, the AlN film) deposited in the process vessel using the first gas and the second gas, by including the step of simultaneously supplying the first gas and the second gas in the CLN Process, it is possible to weaken the bond (for example, aluminum (Al) - nitrogen (N) bond)) between the group 13 element and the group 15 element deposited in the process vessel by the effect of the Group 13 element (for example, boron). Thereby, it is possible to easily etch the film with the second gas. As a result, it is possible to efficiently perform the CLN in a short time. In other words, it is possible to improve the etching rate. In addition, it is also possible to reduce a supply amount of the second gas.

The CLN process is completed through a series of operations mentioned above.

For convenience of explanation, a processing in the CLN step mentioned above may be may be illustrated as follows. Similar notations will be used in the explanations of other embodiments described later. A symbol "→" means that the gases related thereto are sequentially flowed, and A symbol "+" means that there is a timing at which the gases related thereto are simultaneously supplied.

First gas → First gas + Second gas

### <Component Removing Step, Step S30>

Subsequently, a component removing step of removing a component in either the first gas or the second gas remaining in the process chamber 201 after the CLN process is completed will be described with reference to FIG. 6.

In the present step, a cyclic purge is performed. As the purge gas, the inert gas may be used. That is, the purge operation of purging the process chamber 201 by supplying the inert gas into the process chamber 201 and an operation of exhausting the process chamber 201 are alternately and repeatedly performed a predetermined number of times, preferably a plurality number of times. Thereby, it is possible to efficiently and effectively exhaust and remove the component in either the first gas or the second gas from the process chamber 201. When performing the cyclic purge, operations such as the opening and closing operations of the valves 243g to 243i and the opening and closing operation of the APC valve 244 are appropriately controlled in accordance with a timing of the supply of the inert gas.

By performing the cyclic purge mentioned above, it is possible to more efficiently and effectively remove a substance such as the Group 13 element, the Group 16 element, the first halogen element and the second halogen element remaining in the process chamber 201.

### <Pre-coating Step, Step S40>

Subsequently, the pre-coating step of forming a pre-coating film in the process chamber after the CLN step and before the film forming step will be described with reference to FIG. 7.

In the present step, with the empty boat 217 loaded in the process vessel, a pre-coating process is performed to form the pre-coating film on the surface of the component in the process vessel, that is, for example, the inner wall of the reaction tube 203, the outer surfaces of the nozzles 249a to 249c, the inner surfaces of the nozzles 249a to 249c, the inner surface of the MF 209, the surface of the boat 217 and the upper surface of the SC 219. Alternatively, the pre-coating process may be performed with the boat 217 unloaded. In the present step, a nitride film different from the film (which is the film deposited in the process vessel) serving as the CLN target is formed as the pre-coating film.

### <Pre-coating Process>

### <Fourth Gas Supply Step S41>

In the present step, the fourth gas is supplied into the process chamber 201. Specifically, the valve 243f is opened to supply the fourth gas into the gas supply pipe 232a. After a flow rate of the fourth gas is adjusted by the MFC 241f, the fourth gas whose flow rate is adjusted is supplied into the process chamber 201 through the nozzle 249a, and is exhausted through the exhaust port 231a. In the present step, in parallel with a supply of the fourth gas, the valve 243i is opened to supply the inert gas into the gas supply pipe 232a. In addition, in parallel with the supply of the fourth gas, in order to prevent the fourth gas from entering the nozzles 249b and 249c, the valves 243g and 243h may be opened to supply the inert gas into the gas supply pipes 232b and 232c.

In a manner described above, the fourth process gas is supplied into the process vessel. According to the present embodiments, as the fourth process gas, for example, a gas such as a gas containing a transition metal and a gas containing a Group 14 element may be used. As the transition metal, for example, an element such as titanium (Ti), zirconium (Zr), hafnium (Hf), tungsten (W) and molybdenum (Mo) may be used. As the gas containing the transition metal, for example, a halide of the transition metal may be used. As the halide of the transition metal, for example, a gas containing one of TiCl₄, ZrCl₄, HfCl₄, WCl₃, WCl₆, MoCl₃ and MoCl₅ may be used. In addition, the fourth process gas is not limited to a chloride. As the fourth process gas, for example, a fluoride in which chlorine in the substances mentioned above is replaced with fluorine (F) may be used.

### <Purge Step S42>

After a predetermined time has elapsed from a start of the supply of the fourth process gas, the valve 243f is closed to stop the supply of the fourth process gas into the process chamber 201. Then, a substance such as a gas remaining in the process chamber 201 is removed from the process chamber 201 in substantially the same process procedures as in the purge operation of the purge step S12 described above.

### <Second Process Gas Supply Step S43>

Subsequently, the second process gas is supplied into the process chamber 201. Specifically, the valve 243b is opened to supply the second process gas into the gas supply pipe 232b. After a flow rate of the second process gas is adjusted by the MFC 241b, the second process gas whose flow rate is adjusted is supplied into the process chamber 201 through the gas supply pipe 232b and the nozzle 249b, and is exhausted through the exhaust port 231a. In the present step, in parallel with a supply of the second process gas, the valve 243g is opened to supply the inert gas into the gas supply pipe 232b. In addition, in parallel with the supply of the second process gas, in order to prevent the second process gas from entering the nozzles 249a and 249c, the valves 243i and 243h may be opened to supply the inert gas into the gas supply pipes 232a and 232c.

In a manner described above, the second process gas is supplied into the process chamber 201. As the second process gas, for example, a gas such the nitriding gas is supplied into the process chamber 201.

### <Purge Step S44>

After a predetermined time has elapsed from a start of the supply of the second process gas, the valve 243b is closed to stop the supply of the second process gas into the process chamber 201. Then, a substance such as a gas remaining in the process chamber 201 is removed from the process chamber 201 in substantially the same process procedures as in the purge operation of the purge step S12 described above.

### <Performing Predetermined Number of Times, Step S45>

By performing a cycle (wherein the steps S41 to S44 described above are performed non-simultaneously (that is, in a non-synchronized manner) in this order) a predetermined number of times (X times, wherein X is an integer of 1 or 2 or more), it is possible to form a film of a predetermined composition and a predetermined thickness on the wafer 200. According to the present embodiments, for example, as the film formed, a film containing the transition metal is formed. As the film containing the transition metal, for example, a nitride film is formed. As the nitride film containing the transition metal, for example, the TiN film is formed.

### <Third Process Gas Supply Step S46>

Subsequently, after performing the cycle (wherein the steps S41 to S44 described above are performed in this order) a predetermined number of times, the third process gas is supplied into the process chamber 201. Specifically, the valve 243c is opened to supply the third process gas into the gas supply pipe 232c. After a flow rate of the third process gas is adjusted by the MFC 241c, the third process gas whose flow rate is adjusted is supplied into the process chamber 201 through the gas supply pipe 232c and the nozzle 249c, and is exhausted through the exhaust port 231a. In the present step, in parallel with a supply of the third process gas, the valve 243h is opened to supply the inert gas into the gas supply pipe 232c. In addition, in parallel with the supply of the third process gas, in order to prevent the third process gas from entering the nozzles 249a and 249b, the valves 243i and 243g may be opened to supply the inert gas into the gas supply pipes 232a and 232b.

In a manner described above, the third process gas is supplied into the process chamber 201. According to the present embodiments, as the third process gas, for example, a gas containing silicon and hydrogen (H) may be used, and for example, a silane-based gas such as SiH₄ gas, Si₂H₆ gas and Si₃H₈ gas may be used. As the third process gas, for example, one or more of the gases exemplified above may be used.

### <Purge Step S47>

After a predetermined time has elapsed, the valve 243c is closed to stop the supply of the third process gas into the process chamber 201. Then, a substance such as a gas remaining in the process chamber 201 is removed from the process chamber 201 in substantially the same process procedures as in the purge operation of the purge step S12 described above.

### <Performing Predetermined Number of Times>

By performing a cycle (wherein the steps S45 to S47 described above are performed non-simultaneously (that is, in a non-synchronized manner) in this order) a predetermined number of times (Y times, wherein Y is an integer of 1 or 2 or more), it is possible to form a pre-coating film of a predetermined composition and a predetermined thickness on the surface of the component such as an inner wall of the process vessel. According to the present embodiments, for example, as the pre-coating film, a film containing the same element as the film formed on the wafer 200 is formed. In the present embodiments, "the same element as the film formed on the wafer 200" refers to an element contained in the reactive gas used when forming the film on the wafer 200. When the film formed on the wafer 200 is the nitride film, "the same element as the film formed on the wafer 200" refers to the nitrogen element. The pre-coating film is formed as a nitride film containing an element different from the film serving as the CLN target (etching target). In addition, it is preferable that the element serving as a main component of the pre-coating film is an element different from the element serving as a main component of the film formed on the wafer 200. In the present embodiments, when the main component of the film formed on the wafer 200 is, for example, the Group 13 element, the element serving as the main component of the pre-coating film is an element different from the Group 13 element. For example, the element serving as the main component of the pre-coating film is at least one among the transition metal element and the Group 14 element. As the pre-coating film, for example, a film containing one or more of films among the TiN film, the SiN film, the TiSiN film and the like may be used.

In a manner described above, by repeatedly and alternately supplying the fourth process gas and the second process gas into the process chamber 201 and then by supplying the third process gas, the film serving as the pre-coating film and containing the element different from that of the film serving as the CLN target (etching target) is formed on the component such as a quartz surface of the inner wall of the process vessel. As a result, the adhesion to the inner wall of the process vessel is improved. Thereby, it is less likely for the film to peel off from the inner wall and the like. In addition, it is possible to reduce a surface roughness of an initial film of the pre-coating film. In addition, it is also possible to prevent (suppress) the element such as boron contained in the first gas diffusing into the process vessel.

According to the present embodiments, for example, when the BCl₃ gas is used as the first gas, boron is likely to be adsorbed and diffused by quartz, and boron may easily diffuse into SiO₂ or TiN. In other words, even when the pre-coating film is formed with the SiO₂ or the TiN after the CLN step, boron may diffuse into the pre-coating film and adhere to the wafer 200 in the furnace. Thereby, the particles may be generated.

In this process, after the CLN process, a nitride film containing Si is formed in the process vessel, and the Si-containing nitride film is, for example, a TiSiN film or a SiN film.
By coating the inside of the process vessel with a nitride film after the CLN process, it is possible to suppress the diffusion of elements contained in the first gas, such as B, into the process vessel.

That is, by performing the pre-coating step of forming the pre-coating film after the CLN step, it is possible to suppress the diffusion of the element such as the Group 13 element used in the CLN step.

In addition, a supply procedure and a supply timing of each of the second process gas, the third process gas, and the fourth process gas in the pre-coating step are not limited to the supply procedure and the supply timing mentioned above.

After the pre-coating step is completed, the inner atmosphere of the process chamber 201 is purged in substantially the same process procedures as in the purge operation described above. Thereafter, the inner atmosphere of the process chamber 201 is replaced with the inert gas.

The pre-coating process is completed through a series of operations mentioned above. By performing the pre-coating process mentioned above, it is possible to suppress an occurrence of a phenomenon in which a thickness of the film in an initial stage among a plurality of runs (executions) of the film forming step performed after the CLN step differs from a desired thickness of the film. In addition, by performing the pre-coating process mentioned above, it is also possible to prepare an environment and conditions within the process vessel before a subsequent film forming process is performed.

### <Empty Unloading Step>

After the pre-coating process is completed, the SC 219 is lowered by the BE 115 and the lower end of the MF 209 is opened. Then, the empty boat 217 is unloaded (transferred) out of the reaction tube 203 through the lower end of the MF 209. After the boat 217 is unloaded, the shutter 219s is moved such that the lower end opening of the MF 209 is sealed by the shutter 219s through the O-ring 220c.

### (3) Effects According to Present Embodiments

According to the present embodiments, it is possible to obtain one or more of the following effects.
(a) By differentiating the timing at which the supply of the first gas is started and the timing at which the supply of the second gas is started in the CLN step, for example, by starting the supply of the second gas after the supply of the first gas is started, it is possible to weaken the bond in the film deposited in the process vessel by the effect of the component contained in the first gas. Thereby, it is possible to easily etch the film deposited in the process vessel with the second gas.
(b) In addition, by providing the timing at which the first gas and the second gas are simultaneously supplied in the CLN step, it is possible to weaken the bond in the film deposited in the process vessel by the effect of the component contained in the first gas. Thereby, it is possible to easily etch the film deposited in the process vessel with the second gas. As a result, it is possible to efficiently perform the CLN in a short time.
(c) In addition, by performing the cyclic purge as the component removing step after the CLN step is performed, it is possible to efficiently and effectively exhaust and remove the component in either the first gas or the second gas from the process vessel. That is, it is possible to efficiently and effectively remove a substance such as boron (B), sulfur (S), oxygen (O) and chlorine (Cl) remaining in the process chamber 201.
(d) By performing the pre-coating step after the CLN step is performed, it is possible to prevent (suppress) the element such as boron contained in the first gas and the second gas remaining in the CLN step from diffusing from the component in the process vessel to the substrate to be processed later. In addition, it is possible to reduce the surface roughness of the initial film of the pre-coating film. In addition, it is possible to suppress the occurrence of the phenomenon in which the thickness of the film differs from the desired thickness of the film when a subsequent film forming step is performed. In addition, it is also possible to prepare the environment and the conditions within the process vessel in the subsequent film forming step.

### (4) Other Embodiments of Present Disclosure

While the technique of the present disclosure is described in detail by way of the embodiments mentioned above, the technique of the present disclosure is not limited thereto. The technique of the present disclosure may be modified in various ways without departing from the scope thereof. The following modified examples are modified from the CLN process shown in FIG. 6 described above. In addition, in the following description of the modified examples, features different from those of the embodiments mentioned above will be mainly described in detail.

### <First Modified Example>

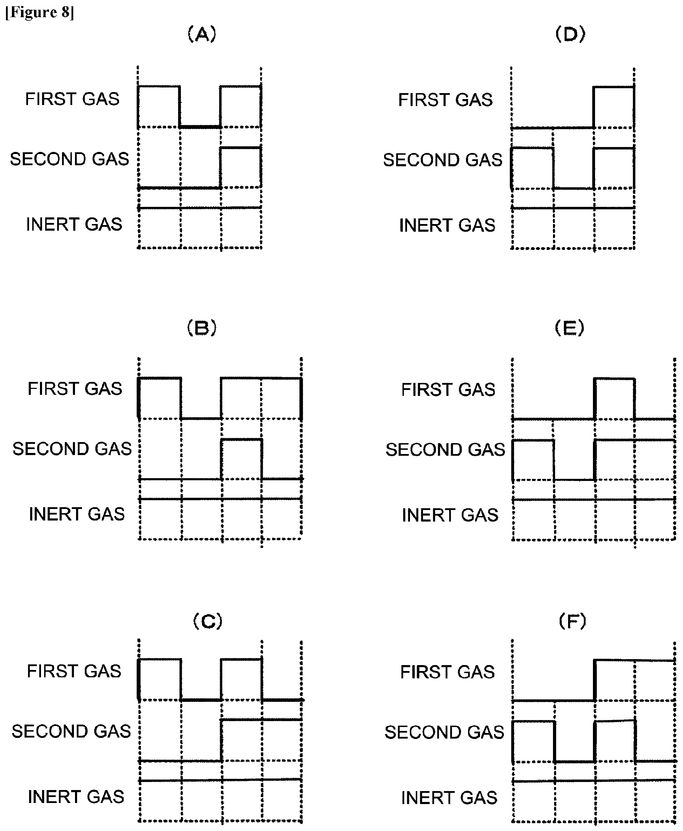

In the present modified example, as shown in FIG. 8(A) and a process sequence shown below, in the CLN step, after the first gas is supplied and the purge operation is performed, the first gas and the second gas are simultaneously supplied. In other words, according to the present modified example, there is a timing at which the first gas and the second gas are simultaneously supplied after the first gas is supplied.

First gas → P + V → First gas + Second gas

In the present specification, "P" means that the inert gas serving as the purge gas is supplied into the process chamber 201, and "V" means that a substance such as a gas remaining in the process chamber 201 is removed from the process chamber 20 by exhausting the inner atmosphere of the process chamber 201. In addition, in the process sequence above, "P + V" means that "P" and "V" are performed simultaneously. However, the present modified example is not limited thereto. For example, at least one among "P" and "V" may be performed. For example, both of "P" and "V" may not be performed.

According to the present modified example, it is also possible to obtain substantially the same effects as the embodiments mentioned above. In addition, according to the present modified example, by supplying and purging the first gas before the first gas and the second gas are simultaneous supplied, it is possible to weaken the bond of the film deposited in the process vessel by the effect of the element such as boron contained in the first gas, and it is also possible to remove at least a part of the film from the process chamber 201.

### <Second Modified Example>

In the present modified example, as shown in FIG. 8B and a process sequence shown below, in the CLN step, after the first gas is supplied and the purge operation is performed, the first gas and the second gas are simultaneously supplied and then the first gas alone is further supplied. In other words, according to the present modified example, there is a timing at which the first gas and the second gas are simultaneously supplied. In addition, in the process sequence of the present modified example, both of "P" and "V" may not be performed. According to the present modified example, it is also possible to obtain substantially the same effects as the embodiments mentioned above.

First gas → P + V → First gas + Second gas → First gas

### <Third Modified Example>

In the present modified example, as shown in FIG. 8(C) and a process sequence shown below, in the CLN step, after the first gas is supplied and the purge operation is performed, the first gas and the second gas are simultaneously supplied and then the second gas alone is further supplied. In other words, according to the present modified example, there is a timing at which the first gas and the second gas are simultaneously supplied. In addition, in the process sequence of the present modified example, both of "P" and "V" may not be performed. According to the present modified example, it is also possible to obtain substantially the same effects as the embodiments mentioned above.

First gas → P + V → First gas + Second gas → Second gas

### <Fourth Modified Example>

In the present modified example, as shown in FIG. 8(D) and a process sequence shown below, in the CLN step, after the second gas is supplied and the purge operation is performed, the first gas and the second gas are simultaneously supplied. In other words, according to the present modified example, there is a timing at which the first gas and the second gas are simultaneously supplied. In addition, in the process sequence of the present modified example, both of "P" and "V" may not be performed.

According to the present modified example, it is also possible to obtain substantially the same effects as the embodiments mentioned above. Second gas → P + V → First gas + Second gas

### <Fifth Modified Example>

In the present modified example, as shown in FIG. 8(E) and a process sequence shown below, in the CLN step, after the second gas is supplied and the purge operation is performed, the first gas and the second gas are simultaneously supplied and then the second gas alone is further supplied. In other words, according to the present modified example, there is a timing at which the first gas and the second gas are simultaneously supplied. In addition, in the process sequence of the present modified example, both of "P" and "V" may not be performed. According to the present modified example, it is also possible to obtain substantially the same effects as the embodiments mentioned above.

Second gas → P + V → First gas + Second gas → Second gas

### <Sixth Modified Example>

In the present modified example, as shown in FIG. 8(F) and a process sequence shown below, in the CLN step, after the second gas is supplied and the purge operation is performed, the first gas and the second gas are simultaneously supplied and then the first gas alone is further supplied. In other words, according to the present modified example, there is a timing at which the first gas and the second gas are simultaneously supplied. In addition, in the process sequence of the present modified example, both of "P" and "V" may not be performed. According to the present modified example, it is also possible to obtain substantially the same effects as the embodiments mentioned above.

Second gas → P + V → First gas + Second gas → First gas

### <Seventh Modified Example>

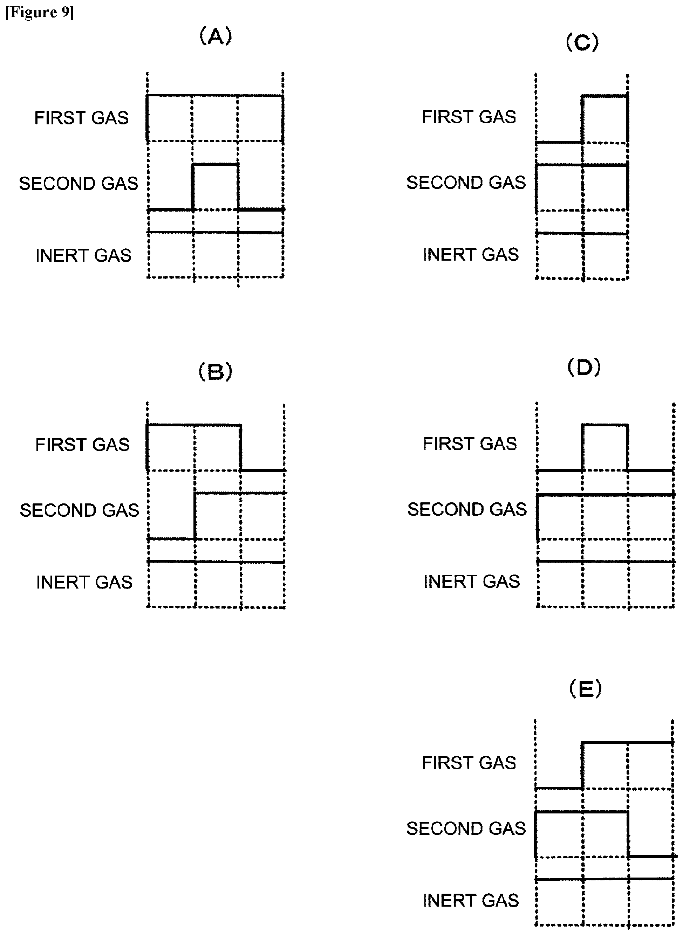

In the present modified example, as shown in FIG. 9(A) and a process sequence shown below, in the CLN step, after the first gas is supplied, the first gas and the second gas are simultaneously supplied without performing the purge operation and the exhaust operation, and then the first gas alone is further supplied. In other words, according to the present modified example, by differentiating the timing at which the supply of the first gas is started and the timing at which the supply of the second gas is started, the supply of the second gas is started after the supply of the first gas is started, and the supply of the first gas is stopped after the supply of the second gas is stopped. In addition, according to the present modified example, there is a timing at which the first gas and the second gas are simultaneously supplied. According to the present modified example, it is also possible to obtain substantially the same effects as the embodiments mentioned above.

First gas → First gas + Second gas → First gas

### <Eighth Modified Example>

In the present modified example, as shown in FIG. 9(B) and a process sequence shown below, in the CLN step, after the first gas is supplied, the first gas and the second gas are simultaneously supplied without performing the purge operation and the exhaust operation, and then the second gas alone is further supplied. In other words, according to the present modified example, by differentiating the timing at which the supply of the first gas is started and the timing at which the supply of the second gas is started, the supply of the second gas is started after the supply of the first gas is started, and the supply of the second gas is stopped after the supply of the first gas is stopped. In addition, according to the present modified example, there is a timing at which the first gas and the second gas are simultaneously supplied.

According to the present modified example, it is also possible to obtain substantially the same effects as the embodiments mentioned above. First gas → First gas + Second gas → Second gas

### <Ninth Modified Example>

In the present modified example, as shown in FIG. 9(C) and a process sequence shown below, in the CLN step, after the second gas is supplied, the first gas and the second gas are simultaneously supplied without performing the purge operation and the exhaust operation. In other words, according to the present modified example, by differentiating the timing at which the supply of the first gas is started and the timing at which the supply of the second gas is started, the supply of the first gas is started after the supply of the second gas is started. In addition, according to the present modified example, there is a timing at which the first gas and the second gas are simultaneously supplied.

Second gas → First gas + Second gas

### <Tenth Modified Example>

In the present modified example, as shown in FIG. 9(D) and a process sequence shown below, in the CLN step, after the second gas is supplied, the first gas and the second gas are simultaneously supplied without performing the purge operation and the exhaust operation, and then the second gas alone is further supplied. In other words, according to the present modified example, by differentiating the timing at which the supply of the first gas is started and the timing at which the supply of the second gas is started, the supply of the first gas is started after the supply of the second gas is started, and the supply of the first gas is stopped before the supply of the second gas is stopped. In addition, according to the present modified example, there is a timing at which the first gas and the second gas are simultaneously supplied. According to the present modified example, it is also possible to obtain substantially the same effects as the embodiments mentioned above.

Second gas → First gas + Second gas → Second gas

### <Eleventh Modified Example>

In the present modified example, as shown in FIG. 9(E) and a process sequence shown below, in the CLN step, after the second gas is supplied, the first gas and the second gas are simultaneously supplied without performing the purge operation and the exhaust operation, and then the first gas alone is further supplied. In other words, according to the present modified example, by differentiating the timing at which the supply of the first gas is started and the timing at which the supply of the second gas is started, the supply of the first gas is started after the supply of the second gas is started, and the supply of the second gas is stopped before the supply of the first gas is stopped. In addition, according to the present modified example, there is a timing at which the first gas and the second gas are simultaneously supplied. According to the present modified example, it is also possible to obtain substantially the same effects as the embodiments mentioned above.

Second gas → First gas + Second gas → First gas

### <Twelfth Modified Example>

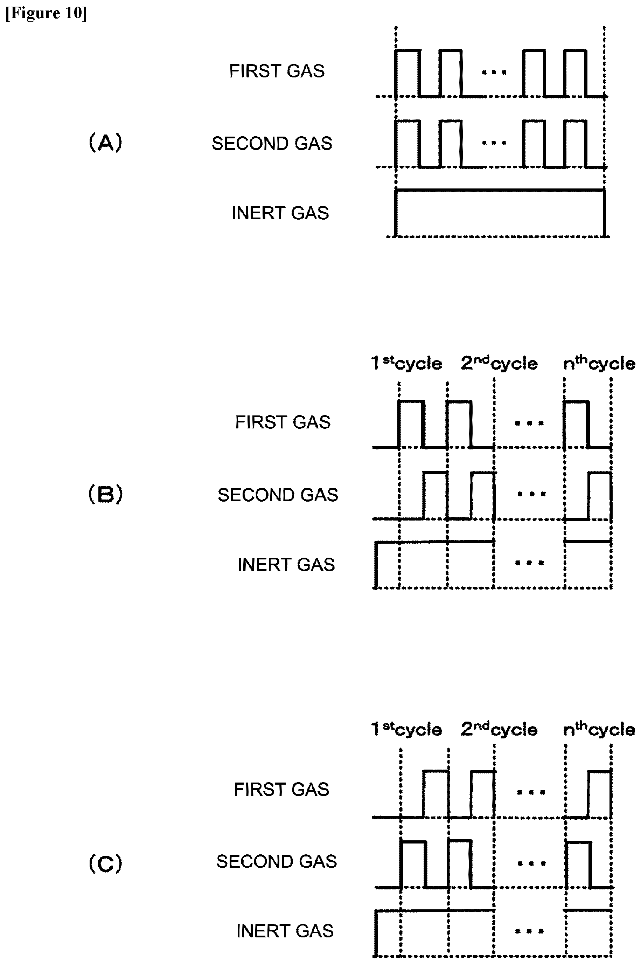

In the present modified example, as shown in FIG. 10(A), the first gas and the second gas are simultaneously supplied in a pulse-wise manner (also referred to as "supplied in a divided manner" or "supplied in an intermittent manner supply") in the CLN step. In other words, according to the present modified example, there is a timing at which the first gas and the second gas are simultaneously supplied. According to the present modified example, it is also possible to obtain substantially the same effects as the embodiments mentioned above.

### <Thirteenth Modified Example>

In the present modified example, as shown in FIG. 10(B) and a process sequence shown below, the first gas and the second gas are alternately and non-simultaneously supplied a plurality of times. In other words, according to the present modified example, in the CLN step, the timing at which the supply of the first gas is started and the timing at which the supply of the second gas is started are set to be different.

(First gas → Second gas) × n (n is an integer of 1 or 2 or more)

In addition, at least one among "P" and "V" may be performed between the supply of the first gas and the supply of the second gas. According to the present modified example, it is also possible to obtain substantially the same effects as the embodiments mentioned above.

### <Fourteenth Modified Example>

In the present modified example, as shown in FIG. 10(C) and a process sequence shown below, the second gas and the first gas are alternately and non-simultaneously supplied a plurality of times. In other words, according to the present modified example, in the CLN step, the timing at which the supply of the first gas is started and the timing at which the supply of the second gas is started are set to be different.

(Second gas → First gas) × n (n is an integer of 1 or 2 or more)

In addition, at least one among "P" and "V" may be performed between the supply of the second gas and the supply of the first gas. According to the present modified example, it is also possible to obtain substantially the same effects as the embodiments mentioned above.

### <Other Embodiments>

For example, the embodiments mentioned above are described by way of an example in which the nitride film is used as the film serving as the CLN target in the CLN step. However, the technique of the present disclosure is not limited thereto. Even when an oxide film such as an aluminum oxide film (AlO film) is used as the film serving as the CLN target, similar to a case where the nitride film is used, it is possible to weaken a bond between oxygen deposited in the process vessel and a specific element. Thereby, it is possible to remove the oxide film deposited in the process vessel. In other words, even in such an embodiment, it is also possible to obtain substantially the same effects as the embodiments mentioned above.

As the oxide film used as the film serving as the CLN target, for example, a film such as the aluminum oxide film, a zirconium oxide film (ZrO film), a hafnium oxide film (HfO film), a titanium oxide film (TiO film), a molybdenum oxide film (MoO film) and a silicon oxide film (SiO film).

For example, the embodiments mentioned above are described by way of an example in which the first gas and the second gas contains chlorine which is a common halogen element, the first gas further contains another element, and the second gas further contains still another element different therefrom. However, the technique of the present disclosure is not limited thereto. For example, it is also possible that the first gas contains a halogen element, and the second gas contains another halogen element different therefrom. For example, the chorine-containing gas may be used as the first gas, and for example, a fluorine-containing gas may be used as the second gas. Even in such an embodiment, it is also possible to obtain substantially the same effects as the embodiments mentioned above.

For example, the embodiments mentioned above are described by way of an example in which the gas containing chlorine and the group 16 element is used as the second gas. However, the technique of the present disclosure is not limited thereto. For example, a gas containing ClF3, Cl2, F2 or NF3, which is a gas contains chlorine or fluorine , may be used as the second gas. Even in such an embodiment, it is also possible to obtain substantially the same effects as the embodiments mentioned above.

For example, in the embodiments mentioned above, a technique for cleaning an inside of the process chamber is described. However, the technique of the present disclosure can be applied to a process (step) of removing (etching) at least a part of the film formed on the substrate. Even in such a case, it is also possible to obtain substantially the same effects as the embodiments mentioned above. When the technique of the present disclosure is applied to a film etching technique, the term "CLN" in the present disclosure can be read as "etching". In addition, the technique of the present disclosure can be applied to the film etching technique, but is preferably applied to CLN where a thick film is used as a removal target. In addition, the technique of the present disclosure is not limited to the etching of the film, and may also be applied to a processing of the substrate, a processing of the structure (component) in the process chamber and a processing of a structure (component) capable of being loaded into the process chamber.

It is preferable that the recipe used to perform each process is prepared individually in accordance with contents of each process. For example, it is preferable that a plurality of recipes are stored in the memory 121c in advance via an electric communication line or the external memory 123. Then, when starting each process, the CPU 121a preferably selects the appropriate recipe among the recipes stored in the memory 121c in accordance with the contents of each process. With such a configuration, various films of different types, different composition ratios, different qualities and different thicknesses can be formed with a high reproducibility using a single substrate processing apparatus. In addition, since a burden on an operator can be reduced, each process can be performed quickly while avoiding a misoperation of the substrate processing apparatus.

In addition, the recipe described above is not limited to creating a new recipe. For example, the recipe may be prepared by changing an existing recipe installed in the substrate processing apparatus in advance. When changing the existing recipe to the new recipe, the new recipe may be installed in the substrate processing apparatus via the electric communication line or the recording medium in which the new recipe is stored. For example, the existing recipe already installed in the substrate processing apparatus may be directly changed to the new recipe by operating the input/output device 122 of the substrate processing apparatus.

For example, the embodiments mentioned above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of processing one or several substrates at once is used to form the film. For example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

In addition, the process sequences of the present disclosure may be performed consecutively (in-situ) in the same process chamber (process vessel). Alternatively, for example, at least one of processes in the process sequence may be performed in another process chamber (process vessel) (ex-situ). In either case, it is possible to obtain substantially the same effects as in the embodiments or the modified examples mentioned above. When the processes are performed in-situ, it is possible to suppress a contamination of the substrate and a change in a surface state of the substrate, which occur when the processes are performed in ex-situ. In addition, it is possible to easily obtain the effects of the present disclosure as compared with a case where the processes are performed ex-situ. In other words, when the processes are performed in-situ, it is possible to improve the quality of the substrate processing as compared with the case where the processes are performed ex-situ. In addition, since a substrate transfer time can be shortened as compared with the case where the processes are performed ex-situ, it is possible to reduce a time for the process sequence. In other words, it is possible to improve the throughput of the substrate processing. On the other hand, when at least one of the processes in the process sequence is performed ex-situ, since a plurality of substrate processing apparatuses can be used in parallel, it is possible to increase the productivity.

Process procedures and process conditions of each process using the substrate processing apparatuses exemplified above may be substantially the same as those of the embodiments or the modified examples mentioned above. Even in such a case, it is possible to obtain substantially the same effects as in the embodiments or the modified examples mentioned above.

In addition, the embodiments and the modified examples mentioned above may be appropriately combined. The process procedures and the process conditions of each combination thereof may be substantially the same as those of the embodiments mentioned above or the modified examples mentioned above.

### [Description of Reference Numerals]

| | | | |
|---|---|---|---|
| 200 | wafer (substrate) | 203 | reaction tube |

## Claims

1. An etching method comprising
a step of removing at least a part of a film by supplying a first gas containing a first halogen element and a second gas containing a second halogen element to the film.

2. The etching method of claim 1, wherein the first halogen element is chlorine.

3. The etching method of claim 2, wherein the first gas is a gas containing a Group 13 element.

4. The etching method of claim 1, wherein the second halogen element is chlorine.

5. The etching method of claim 1 or 3, wherein the second gas is a gas containing a Group 16 element.

6. The etching method of claim 1 or 3, wherein the second gas is a gas containing two of Group 16 elements.

7. The etching method of claim 5, wherein the second gas is a gas containing one of SOCl₂ and SO₂Cl₂.

8. The etching method of claim 1, wherein the first gas and the second gas contain a common halogen element, the first gas further contains another element, and the second gas further contains still another element different therefrom.

9. The etching method of claim 1, wherein a timing at which the first gas and the second gas are simultaneously supplied is provided in the step of removing at least the part of the film.

10. The etching method of claim 1 or 9, wherein, in the step of removing at least the part of the film, a timing at which a supply of the first gas is started and a timing at which a supply of the second gas is started are set to be different

11. The etching method of claim 1 or 9, wherein, in the step of removing at least the part of the film, a supply of the second gas is started after a supply of the first gas is started.

12. The etching method of claim 1 or 9, wherein, in the step of removing at least the part of the film, a supply of the first gas is started after a supply of the second gas is started.

13. The etching method of claim 1, further comprising
a step of removing a component contained in at least one among the first gas and the second gas after the step of removing at least the part of the film.

14. The etching method of claim 13, wherein, in the step of removing the component, a cyclic purge is performed.

15. The etching method of claim 1, wherein the film is a film formed in a process vessel.

16. The etching method of claim 15, further comprising
a step of forming, in the process vessel, a film different from the film serving as a removal target after the step of removing at least the part of the film.

17. The etching method of claim 1, wherein the film is a film formed on a substrate.

18. A method of manufacturing a semiconductor device, comprising
a step of removing at least a part of a film by supplying a first gas containing a first halogen element and a second gas containing a second halogen element to the film.

19. A program that causes a substrate processing apparatus, by a computer, to perform:
a step of removing at least a part of a film by supplying a first gas containing a first halogen element and a second gas containing a second halogen element to the film.

20. A processing apparatus comprising:
a first gas supplier configured to supply a first gas containing a first halogen element to a film;
a second gas supplier configured to supply a second gas containing a second halogen element to the film; and
a controller configured to be capable of controlling the first gas supplier and the second gas supplier to supply the first gas and the second gas to the film such that a process of removing at least a part of the film is performed.
